# EUROPEAN PATENT APPLICATION

(11) **EP 4 492 933 A1**
(43) Date of publication of application: **15.01.2025**
(21) Application number: 23315277.6
(22) Date of filing: 11.07.2023
(51) Int. Cl.: H05K 7/20

(54) **DC/DC CONVERTER TWIN ASSEMBLY WITH OPTIMIZED COOLING**

(71) Applicant: H2X Ecosystems, 35170 Bruz (FR)
(72) Inventor: Paul, Stéphane, 29200 BREST (FR); Fleureau, Jean-Luc, 29460 DAOULAS (FR)
(74) Representative: Yes My Patent

(57) **Abstract**

An electrical converter assembly (10) of the DCDC type, the converter assembly comprising a frame (5) defining a mounting base (6) extending in a mounting plane, a first converter module, a second converter module identical to the first converter module, each converter module comprising a mother board extending in a reference plane (XY), the reference plane comprising a first direction (X1;X2) and second direction (Y1;Y2), each converter module having a heat sink with cooling fins, the converter assembly comprising a wind tunnel comprising fan(s), wherein each of the first and second converter module is mounted on the mounting base of the frame with the reference plane arranged parallel to the mounting plane, wherein the first direction (XI) of the mother board of the first DCDC module lies opposite to the first direction (X2) of the mother board of the second DCDC module.

## Description

### FIELD OF THE DISCLOSURE

The instant disclosure relates to electrical converters, in particular DC/DC converters.

In hydrogen-based transportation systems, there are provided vehicles comprising an electric driveline moved by a fuel cell device supplied from a pressurized hydrogen reservoir arranged aboard the vehicle. The fuel cell device provides electrical power under an output voltage ranging from 20 volts to 40 volts. The fuel cell device supplies an onboard battery pack having a voltage higher than the output voltage of the fuel cell device. Therefore, a DC/DC step-up converter is required to transfer electrical energy from the fuel cell device to the battery pack.

### BACKGROUND OF THE DISCLOSURE

In general, a DC/DC converter exhibits thermal losses and the heat related to thermal losses must be evacuated. The heat evacuation function, also named cooling function, must be ensured, whatever the environmental temperatures surrounding the DC/DC converter. The heat evacuation function is thus a critical function in order to reliably operate a DC/DC converter. Also in vehicles, devices have to be the more compact possible to enhance integration and optimize room usable by vehicle occupants and other vehicle functions.

The inventors have sought to design a boost type DC/DC converter having a rated power output of 5kW. One of the solutions to do that consists in associating in parallel two DC/DC step-up/boost converters, each having a rated power output of 2,5kW. The inventors have endeavoured to improve the overall trade-off between cooling performance, device size and required volume, and also cost-effectiveness.

### SUMMARY OF THE DISCLOSURE

According to one aspect of the present disclosure, it is disclosed an electrical converter assembly (10) configured to convert a DC source preferably into a higher voltage DC output (i.e. boost DCDC), the converter assembly configured to ouptut a rated amount of power (PWO) comprised between 2 kW and 10 kW,
the converter assembly comprising a frame (5) defining a mounting base (6) extending in a mounting plane (PUV) comprising a first base direction and a second base direction,
a first converter module (1A), a second converter module (1B), substantially identical to the first converter module,
each of the first and second converter module comprising a mother board (2) extending in a reference plane (XY), the reference plane comprising a first direction (X1;X2) and second direction (Y1;Y2), each of the first and second converter module comprising at least a heat sink (3) with cooling fins (30), the converter assembly comprising at least one fan (8), wherein each of the first and second converter module (1A,1B) is mounted on the mounting base of the frame with the reference plane arranged parallel to the mounting plane (PUV), wherein the first direction (X1) of the mother board of the first converter module lies opposite to the first direction (X2) of the mother board of the second converter module.

It should be understood that the second converter module is in a position rotated 180° around an axis perpendicular to the reference plane, with reference to the position of the first converter module. In other words, first and second converter modules are disposed in an alternate way or in an inverted manner. This may be called 'alternate twins'.

Stated otherwise, each converter module comprises generally, along the first direction, a first region and a second region, the first region undergoing a higher thermal dissipation flow compared to the second region. With the promoted alternate positions of first and second converter modules, an air stream portion cools firstly the first region of the first converter module and then the second region of the second converter module and another air stream portion cools firstly the second region of the first converter module and then the first region of the second converter module. This proves to be an overall optimized solution for cooling.

Indeed, if the converter modules were arranged in a similar position next to one another, the air flow requirement would be higher. Thanks to the alternate position arrangement, as promoted, the size and power of the air flow and wind tunnel can be designed in a just necessary logic, and contributes to an enhanced compactness.

It should be noted that the cooling fins are lying within the air flow circulated by the fans(s).

The converter module is typically here a boost DCDC converter module, i.e. a step-up converter. The converter module can also be a buck DCDC converter, i.e. a step-down converter.

Each mother board (2) may have a respective reference point (O1, O2) from which the respective first direction (X1;X2) and second direction (Y1;Y) are taken. Said reference point is preferably close to a corner of the mother board. It can be one of the fixing holes.

According to one aspect, the rated amount of power (PWO) is 5 kW. Accordingly, each converter module has a power output of 2,5 kW. Further, the two converter modules are connected in parallel to output electrical power.

In exemplary embodiments, the rated amount of power output can be comprised between 3 kW and 8 kW.

According to a further aspect, the first and second converter modules are adjacent along the second base direction (V). In other words, the converter modules are arranged next to one another, along second base direction V. Further, the two mother boards are aligned in the mounting plane. Accordingly, a single reception hole is provided in the mounting frame.

According to an alternate arrangement, first and second converter modules can be spaced along the second base direction V.

According to a further aspect, the converter assembly comprises a wind tunnel (7) to convey air circulated by the at least one fan (8). The axis of the fan(s) is parallel to the second base direction (V). There is provided an enclosure (4) to tightly convey air flow in the wind tunnel. The air flow in the wind tunnel is therefore decoupled from the air located outside the wind tunnel.

According to a further aspect, the heat sink comprises a heat sink body (32), wherein the heat sink body having a length (L3) larger than the length (L1) of the mother board along the first direction (X1). *Cooling effect is therefore maximised.*

According to a further aspect, the heat sink comprises a heat sink flange (31) wherein the heat sink flange is interposed between the mother board and the mounting base. The heat sink flange is attached to the mounting frame. The motherboard is attached to the heat sink body and is not attached directly to the mounting frame. A portion of the thermal flow is transferred by thermal conduction from the heat sink to the mounting frame. The frame acts as heat evacuation item. The frame contributes to cooling. In particular if the frame is thermally coupled to a cold source, it can contribute to enhance cooling performance.

According to a further aspect, each of the first and second converter modules may have an input voltage comprised between 20 to 48 Volts and an output voltage comprised between 88 volts and 120 volts. A typical voltage output is comprised between 100 volts and 110 volts.

According to an alternate arrangement, a typical output voltage is comprised between 45 volts and 60 volts, in this case the battery has a nominal rating of 48 volts.

According to a further aspect, each of the first and second converter modules produces up to 250 Watts of thermal energy to be evacuated in cruise operation.

According to a further aspect, the thermal energy to be evacuated is comprised between 75W and 250W (per module). According to a further aspect, the thermal energy to be evacuated is 500 W for the whole converter assembly.

According to a further aspect, at an input voltage nominal of 22V and an output voltage of 104 V, the operation exhibits a 5% loss, namely 125W per converter module.

According to a further aspect, each the first and second converter modules comprises a daughter board. This daughter board is coupled to the motherboard. The daughter board is a signal board, preferably multilayer, with thin layers, whereas by contrast the motherboard has larger track thickness to convey higher current ratings.

According to a further aspect, the cooling fins occupy substantially the whole length of the heat sink body along the first direction X1, i.e. along the first base direction U. *The cooling capacity is enhanced*.

According to a further aspect, the cooling fins of the second converter module are aligned with the cooling fins of the first converter module. This arrangement favours an efficient airflow along the sides of the fins. There is no pressure drop, no vortex, no turbulence in the area joining the cooling fins of the first and second converters. Cooling fins extend along the second base direction V and along the downward direction Z.

According to a further aspect, there are provided two cooling fans, each having an axis parallel to the second base direction. This provides redundancy and enhances dependability of the whole system. In case one fan is failing, the other can still provide an air flow meanwhile a derating action is taken. However, in other configurations, there may be provided a single fan in the converter assembly.

According to a further aspect, the converter assembly is deprived of pipe(s), and deprived of liquid. The promoted configuration is cost effective, reliable and leak free.

The current disclosure is also directed at a system for providing electric power to a terrestrial vehicle, comprising a fuel cell apparatus (70), an electric energy storage battery (16), a drive motor (18) and an electrical converter assembly (10) as described above, wherein the electrical converter assembly is configured to deliver a substantially constant electrical power to the battery, and wherein the battery is configured to supply the drive motor with a changeably power according to vehicle motion.

### BRIEF DESCRIPTION OF THE DRAWINGS

Other features and advantages of the invention appear from the following detailed description of its embodiments, given by way of non-limiting example, and with reference to the accompanying drawings, in which:
- Figure 1 shows a schematic block diagram of the system aboard a vehicle,
- Figure 2 illustrates a perspective view of a converter module involved in the present invention,
- Figure 3 illustrates schematically a plan view of a converter module involved in the present invention,
- Figure 4 illustrates a perspective view of a converter assembly according to the present invention,
- Figure 5 shows schematically a plan view of a converter assembly according to the present invention,
- Figure 6 shows schematically a sectional view of a converter assembly according to the present invention, taken in a plane transverse to the cooling air flow,
- Figure 7 illustrates diagrammatically a chart of thermal flow,
- Figure 8 illustrates a partial perspective view of a converter assembly,
- Figure 9 schematically a sectional view of a converter assembly according to the present invention, taken in a plane parallel to the cooling air flow,
- Figure 10 illustrates a detailed sectional view of a border of the mounting base.

### DETAILED DESCRIPTION OF THE DISCLOSURE

In the figures, the same references denote identical or similar elements. For sake of clarity, various elements may not be represented at scale.

### General context

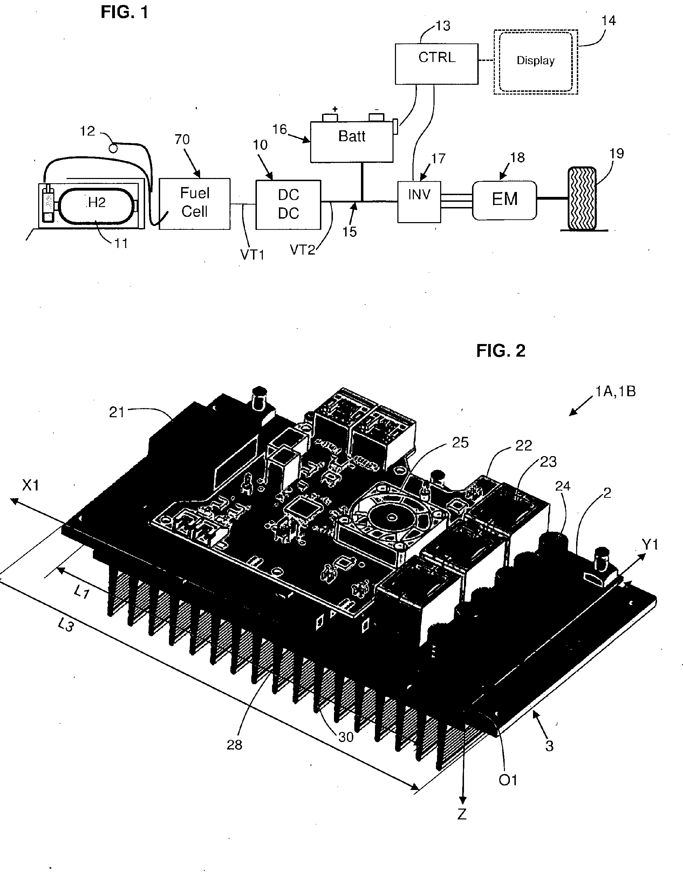

Figure 1 shows a schematic block diagram of a system aboard a vehicle. The vehicle comprises an electric machine **18** driving wheels **19.** The electric machine **18** is controlled by an inverter **17.** The inverter 17 is controlled by an onboard management unit **13.** The inverter 17 is supplied by a power network **15.** The power network is connected to the power battery **16** and is connected to the output of a DC/DC converter device **10.** The converter device is supplied by a fuel cell **70.** The fuel cell **70** is supplied in hydrogen gas from an onboard reservoir **11.** The vehicle may comprise one display device **14,** possibly controlled by the management unit **13.**

The electric machine **18** can be controlled in a traction mode as a motor, and sometimes the electric machine can be controlled conversely as a motor in conditions of regenerative braking.

In addition, the vehicle may comprise a refill port **12,** so that the onboard hydrogen reservoir **11** can be refilled in situ.

The vehicle at stake here can be a passenger car, a light truck, a city car, a motorcycle, without excluding other types, including railway vehicles.

We now focus more specifically on the DC/DC converter device. Figures 2 to 10 relate to an electrical converter assembly **10** suitable to form the converter device required in the vehicle discussed above.

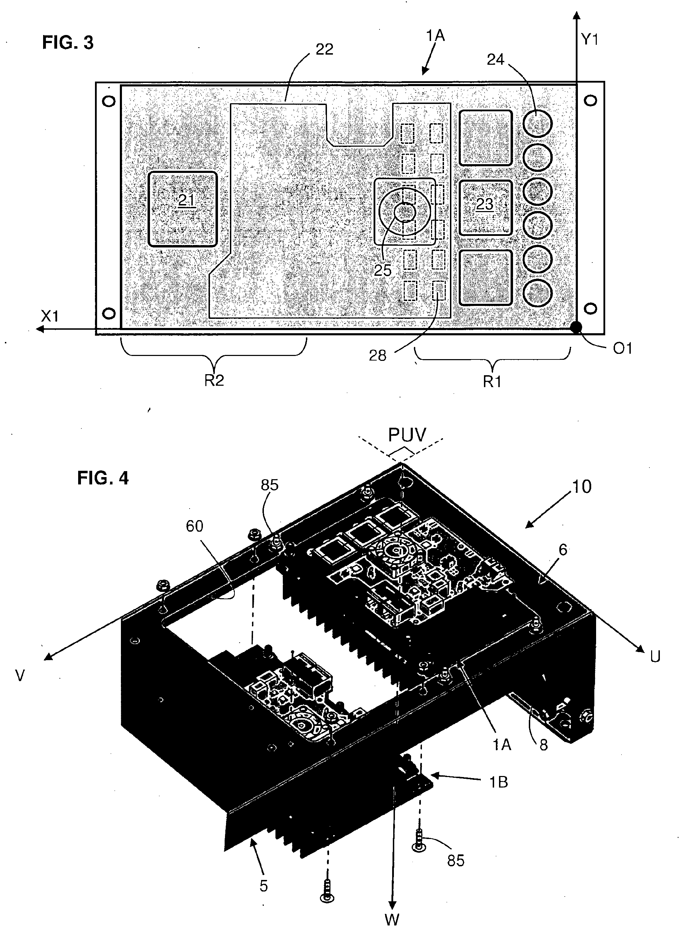

The converter assembly **10** comprises a frame **5** defining a mounting base **6.** The mounting base 6 extends in a mounting plane referenced **PUV.** The mounting plane PUV comprises a first base direction **U** and a second base direction **V** (cf Fig 4). The frame 5 is preferably made of metal.

The converter assembly **10** comprises a first converter module referenced **1A** and a second converter module referenced **1B.** The second converter module 1B is substantially identical to the first converter module **1A.** The two converter modules are connected electrically in parallel to output a desired electrical power.

Generally, the converter assembly is configured to ouptut a rated amount of power **PWO** comprised between 2 kW and 10 kW. Half of this power is supplied by one of the converter module. In other exemplary embodiments, the rated amount of power output can be comprised between 3 kW and 8 kW.

In a specific embodiment, the rated amount of power **PWO** is 5 kW. In this case, each converter module **1A,1B** has a power output of 2,5 kW.

In case the converter assembly is used in a vehicle together with a fuel cell supplied by hydrogen gas, as the configuration illustrated as figure 1, the power processed by the converter assembly is somehow steady. The output power does not change rapidly. Even though. The current demand from the inverter **17** and the electric motor **18** changes rapidly and this dynamic behaviour is supported by the battery **16.** Therefore, there is no peak power or peak current to consider within the converter assembly. The power output of the converter modules follows the supply in hydrogen gas to the fuel cell which evolves slowly over time.

Each of the first and second converter modules may have an input voltage **VT1** comprised between 20 to 48 Volts and an output voltage **VT2** comprised between 88 volts and 120 volts. A typical voltage output is comprised between 100 volts and 110 volts. In such case, the battery 16 has a nominal rating of 90 volts. Other voltage ratings are not excluded, like higher voltages.

According to an alternate arrangement, a typical output voltage is comprised between 45 volts and 60 volts, in this case the battery **16** has a nominal rating of 48 volts.

The first converter module **1A** comprises a mother board **2** extending in a reference plane (generically referenced XY), the reference plane comprising a first direction **X1** and second direction **Y1.** The mother board **2** of the first converter module **1A** has a reference point **O1** from which the first direction **X1** and second direction **Y1** are taken.

The second converter module **1B** comprises a mother board **2** extending in a reference plane comprising a first direction **X2** and second direction **Y2.** The mother board **2** of the second converter module **1B** has a reference point **O2** from which the first direction **X2** and second direction **Y2** are taken.

As apparent from figure 3, the reference point **O1** (and **O2** respectively) is preferably located close to a corner of the mother board.

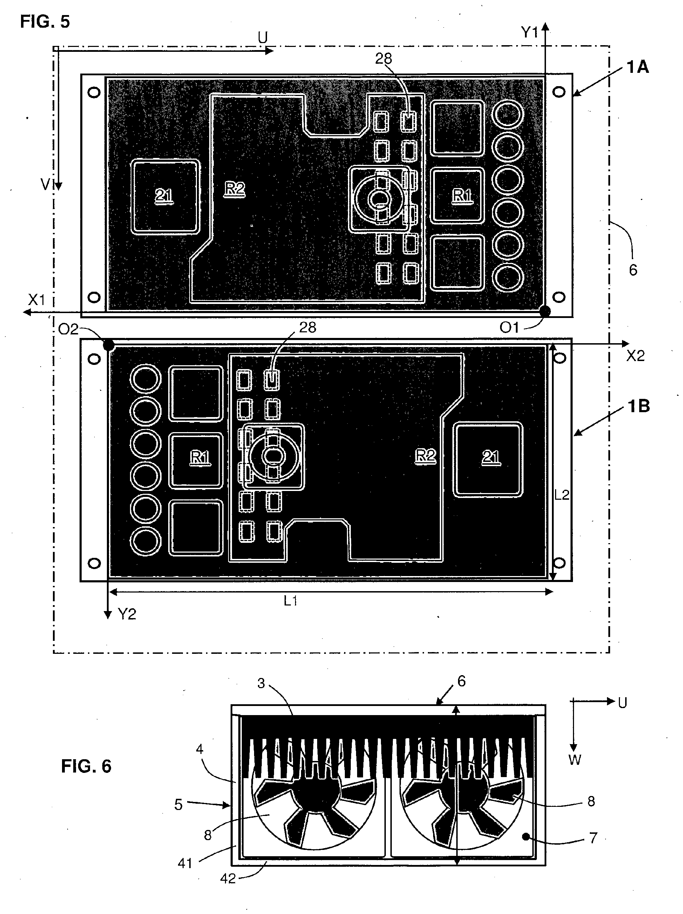

As illustrated from figures 4 and 5, each of the first and second converter module 1A,1B is mounted on the mounting base **6** of the frame with the reference plane (**X1Y1** and respectively **X2Y2**) arranged parallel to the mounting plane **PUV.**

According to an advantageous feature promoted herein, the second converter module 1B is in a position rotated 180°, with reference to the position of the first converter module 1A, as shown on figure 5. Said otherwise, first and second converter modules are disposed in an alternate way or in an inverted manner. It is to be noted that the rotation of 180° mentioned above is about Z axis.

More precisely, turning to figure 5, the first direction **X1** of the mother board of the first converter module **1A** is directed towards the **U-** direction, whereas the first direction **X2** of the mother board of the second converter module **1B** is directed towards the U+ direction, i.e. opposite to the orientation of the first converter module **1A.**

Each converter module comprises a main relay **21,** coils **23,** capacitors **24,** a plurality of MOSFETs **28.** Each converter module comprises a daughter board **22,** accommodating a microcontroller cooled by a local fan **25.**

The daughter board **22** is coupled mechanically and electrically to the mother board 2.

The mother board **2** has a length **L1** along its first direction X1 coinciding with the first base direction **U** when assembly is done.

The mother board 2 has a width **L2** along its second direction Y1 coinciding with the second base **V** direction when assembly is done.

As illustrated in figure 3, each converter module comprises generally, along the first direction, a first region **R1** and a second region **R2,** the first region **R1** undergoing a higher thermal dissipation flow compared to the second region **R2.** With the promoted alternate positions of first and second converter modules, an air stream portion cools firstly the first region **R1** of the **first** converter module **1A** and then the second region **R2** of the second converter module **1B** and another air stream portion cools firstly the second region **R2** of the first converter module **1A** and then the first region **R1** of the second converter module **1B.** This proves to be an overall optimized solution for cooling.

According to an aspect, the first and second converter modules **1A,1B** are adjacent along the second base direction **V.** In other words, the converter modules are arranged next to one another, along second base direction V, the two mother boards are aligned in the mounting plane. Accordingly, a single reception hole **60** is provided in the mounting frame.

However, in other embodiments, first and second converter modules can be spaced along the second base direction **V,** possibly with two distinct holes.

Each of the first and second converter module comprising at least a heat sink **3** with protruding cooling fins **30.** The heat sink 3 is coupled to the motherboard on the side opposite to the side where the daughter board is mounted. The heat sink 3 is thermally coupled to the back face of the mother board (bottom face in the illustrated figures).

The converter assembly comprises two fans **8.** Generally speaking, the converter assembly comprises at least one fan. Each fan **8** has an axis **A8,** parallel to the second base direction **V.**

The converter assembly comprises a wind tunnel **7** to convey air circulated by the one or two fans **8.**

There is provided an enclosure **4** to tightly convey air flow in the wind tunnel. The air flow in the wind tunnel is therefore decoupled from the air located outside the wind tunnel. The enclosure **4** comprises two opposite side walls **41** and bottom wall **42,** this complements the top wall formed by the heat sinks **3** and the mounting base **6.** The air flow in the wind tunnel is therefore decoupled from the air located outside the wind tunnel.

The height of the wind tunnel is slightly less than the height **H4** of the frame **5.**

The heat sink comprises a heat sink body **32.** The heat sink body 32 collects calories from the back face of the mother board.

The heat sink body has a length **L3** which is larger than the length **L1** of the mother board along the first direction **X1.** The width of the wind tunnel is substantially about **L1.**

The cooling fins occupy the whole length **L1** along the first direction **X1.**

The heat sink comprises a heat sink flange **31.** The heat sink flange **31** is interposed between the mother board **2** and the mounting base 6. The heat sink flange **31** is attached to the mounting frame by bolts **85.** A portion of the thermal flow is transferred by conduction from the heat sink 3 to the mounting frame **6.** The mother board **2** is attached to the heat sink body 32.

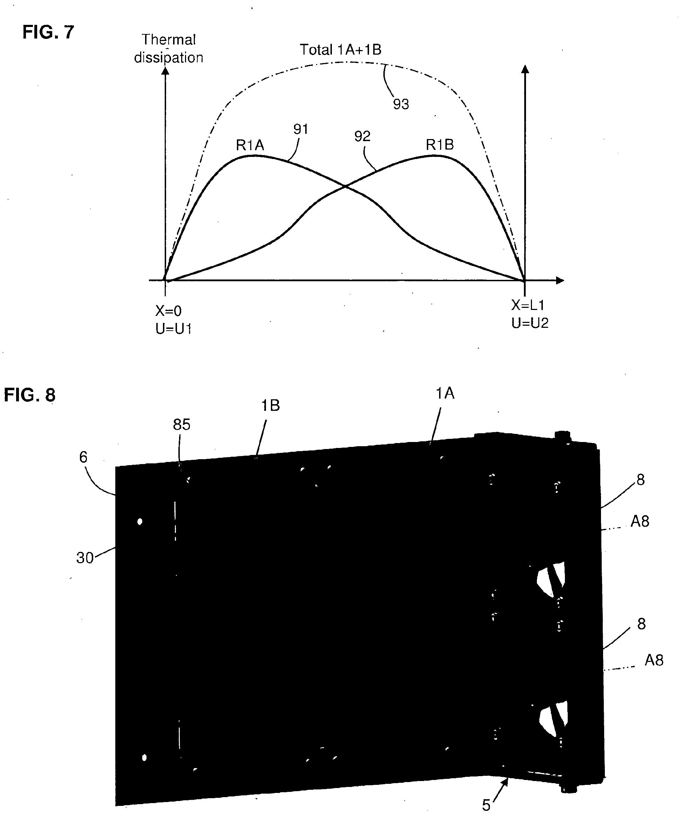

As apparent from figures 6 and 8, the cooling fins **30** of the second converter module are aligned with the cooling fins **30** of the first converter module. Aeraulic performance of the air flow **AF** is thus optimal.

The cooling fins extend along second base direction **V** and downward direction **Z.** The section of the fins is tapered from the base to the free end. The total height of the fins is denoted **H3.** In some embodiments, **H3** can be comprised between 20% of **H4** and 35% of **H4.**

Each of the first and second converter modules produces up to 250 Watts of thermal energy to be evacuated in cruise operation.

The thermal energy to be evacuated is comprised between 75W and 250W (per module). The thermal energy to be evacuated ranges up to 500 W for the converter assembly.

According to a further aspect, at an input voltage nominal of 22V and an output voltage in 104 V out, the operation exhibits a 5% loss, namely 125W per converter module.

Turning now to figure 7, the distribution of thermal dissipations across the length **L1** of the converter module are shown (along first base direction U). The curve **91** denotes distribution of thermal dissipation across the length **L1** of the first converter module **1A.** The apex **R1A** corresponds to the first region of the first converter module where the maximum thermal dissipation takes place. In one embodiment, this apex corresponds to the position of the group of Mosfets transistors **28.**

The curve **92** denotes distribution of thermal dissipation across the length **L1** of the first converter module **1B.** The apex **R1B** corresponds to the first region of the second converter module 1B where the maximum thermal dissipation takes place.

The curve **93** denotes the sum of curves **91** and **92.** Curve **93** represents the total distribution of thermal dissipation along the first base direction U.

We note that curve **93** is rather flat in a wide middle section, which proves the optimal use of the air flow.

It is to be noted that the converter assembly is deprived of pipe(s), and deprived of liquid, no heat pipe or phase change material. Only air flow **AF** is used, rendering the promoted system cost effective.

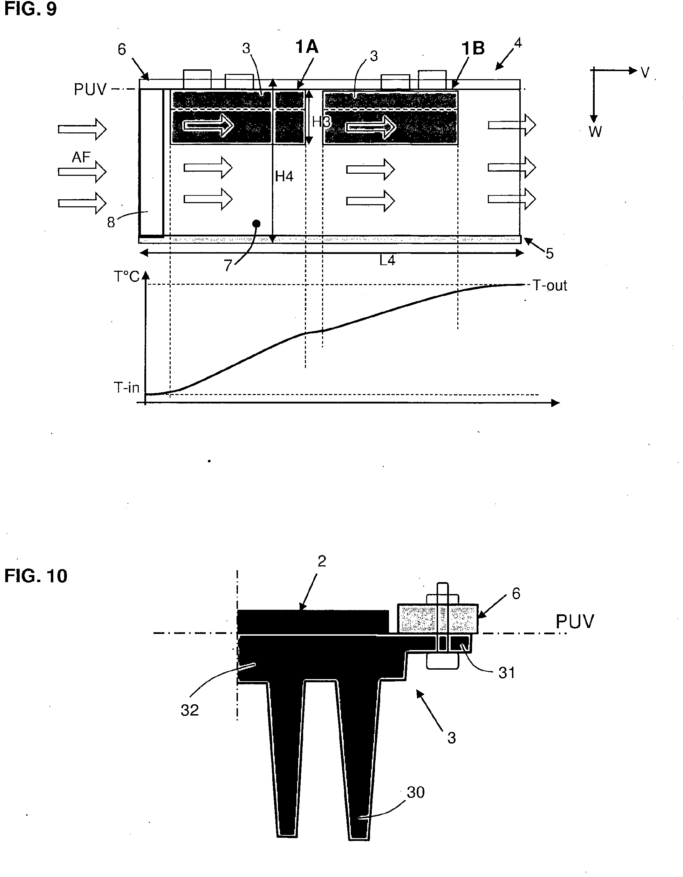

As shown in figure 9, the air warms along its path of length **L4** along first second direction V, from a temperature **T-in** to a second temperature **T-out.**

The mounting frame **5** is made of aluminium. The heat sink **3** is made of aluminium. The heat sink can be a single piece I don't as illustrated at the figures. In other embodiments the heat sink **3** may comprise several parts. The mother board **2** is a power PCB, for example made of epoxy.

According to one embodiment with a power output of 2,5 kW per converter module, the dimensions can be the following : **L1** is comprised between 180 mm and 220 mm, **L2** is comprised between 120 mm and 150 mm, **H4** is comprised between 80 mm and 100 mm, L4 is comprised between 250 mm and 320 mm. However, other form factors are possible.

## Claims

1. An electrical converter assembly (10) configured to convert a DC source preferably into a higher voltage DC output, the converter assembly configured to ouptut a rated amount of power output (PWO) comprised between 2 kW and 10 kW,
the converter assembly comprising a frame (5) defining a mounting base (6).extending in a mounting plane (PUV) comprising a first base direction (U) and a second base direction (V), a first converter module (1A), a second converter module (1B), substantially identical to the first converter module,
each of the first and second converter module comprising a mother board (2) extending in a reference plane (XY), the reference plane comprising a first direction (X1;X2) and second direction (Y1;Y2),
each of the first and second converter module comprising at least a heat sink (3) with cooling fins (30), the converter assembly comprising at least one fan (8),
wherein each of the first and second converter module (1A,1B) is mounted on the mounting base of the frame with the reference plane arranged parallel to the mounting plane (PUV), wherein the first direction (X1) of the mother board of the first converter module lies opposite to the first direction (X2) of the mother board of the second converter module.

2. The converter assembly according to claim 1, wherein the rated amount of power output (PWO) is 5 kW.

3. The converter assembly according to any of the claims 1 to 2, wherein the first and second converter modules are adjacent along the second base direction (V).

4. The converter assembly according to any of the claims 1 to 3, wherein the converter assembly comprises a wind tunnel (7) to convey air circulated by the at least one fan (8).

5. The converter assembly according to any of the claims 1 to 4, wherein the heat sink comprises a heat sink body (32), wherein the heat sink body having a length (L3) larger than the length (L1) of the mother board along the first direction (X1).

6. The converter assembly according to any of the claims 1 to 5, wherein the heat sink comprises a heat sink flange (31) wherein the heat sink flange is interposed between the mother board and the mounting base.

7. The converter assembly according to any of the claims 1 to 6, wherein each of the first and second converter modules has an input voltage (VT1) comprised between 20 to 48 Volts and an output voltage (VT2) comprised between 88 volts and 120 volts.

8. The converter assembly according to any of the claims 1 to 7, each of the first and second converter modules (1A,1B) produces up to 250 Watts of thermal energy to be evacuated in cruise operation.

9. The converter assembly according to any of the claims 1 to 8, each of the first and second converter modules comprises a daughter board (22).

10. The converter assembly according to claim 5, wherein the cooling fins occupy substantially the whole length of the heat sink body (32) along the first direction (X1).

11. The converter assembly according to any of the claims 1 to 10, wherein the cooling fins of the second converter module are aligned with the cooling fins of the first converter module.

12. The converter assembly according to any of the claims 1 to 11, wherein there are provided two cooling fans, each having an axis (A8) parallel to the second base direction (V).

13. The converter assembly according to any of the claims 1 to 12, deprived of pipe(s), and deprived of liquid.

14. A system for providing electric power to a terrestrial vehicle, comprising a fuel cell apparatus (70), an electric energy storage battery (16), a drive motor (18) and an electrical converter assembly (10) according to any of the claims 1 to 13, wherein the electrical converter assembly is configured to deliver a substantially constant electrical power to the battery, and wherein the battery is configured to supply the drive motor with a changeably power according to vehicle motion.
